# EUROPEAN PATENT APPLICATION

(11) **EP 0 570 654 A1**
(43) Date of publication of application: **24.11.1993**
(21) Application number: 92830239.7
(22) Date of filing: 20.05.1992
(51) Int. Cl.: G01R 27/20, H04M 3/30

(54) **A remote eart resistance meter**

(71) Applicant: P.C.E. S.r.l., 80078 Pozzuoli, Napoli (IT)
(72) Inventor: Fuschetto, Michele Alfonso, I-80078 Pozzuoli, Napoli (IT)
(74) Representative: Gristina, Giorgio

(57) **Abstract**

The subject of the invention is an earth resistance meter fit to carry out the measurement without having to disconnect the ground cable from the apparatus which it is connected with; the measurement can be made remotely.

## Description

The earth connection of an electric apparatus is carried out for the known safety exigencies, but the daily check of the resistance of the earth plate is not provided because the present technology would involve an unacceptable economic burden.

The present invention introduces an innovatory idea on the basis whereof it is possible to keep under control, also continuously, the resistance of the earth plate and it is possible to carry out the measurement without having to disconnect the cable from the apparatus.

Moreover, on the ground of the novel idea it is possible to carry out the resistance measurements also remotely.

The solution idea consists in measuring the current that flows in the earth connection in consequence of a suitable voltage applied to the line which the earth connection is part of; this idea has been applied to a telephone system for measuring the earth resistance of earth plates connected with the line dischargers.

In the annexed drawing the electrical diagram is shown that allows the measurement according to the present invention to be carried out.

In said drawing with 1 and 2 a telephone pair is indicated coming from the distribution box 3, in such a box the dischargers, that need of the earth connection 4 for their operation, are assumed to be arranged.

The measurement transformer 5 is inserted on the earth connection.

A milliammeter 6, a voltmeter 7 and a frequency meter 8 are inserted on the pair.

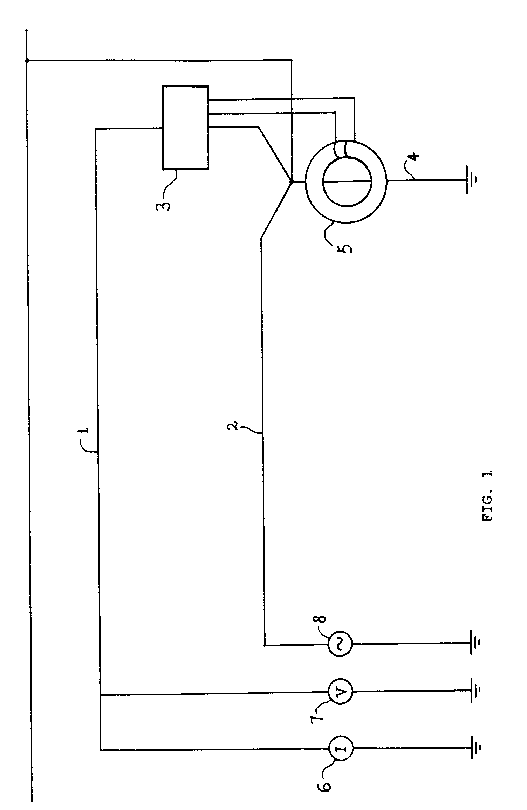

With reference to the figure, it can be observed that the usual pair directed to the user is made to pass through the measuring device and then returned to the network for the distribution.

This operation is necessary to be able to examine the state of the line and to determine if the user is in conversation or idle.

Moreover, at the time of measurement the telephone exchange is disconnected to avoid interferences.

Contemporaneously, the current that flows through the cable is measured by means of a toroid.

A first processing of the data is carried out on the site, the other data are sent to the central device that controls and processes the whole.

The suggested earth resistance meter allows a remote measurement of the value of the resistance of the earth plate without ever having to disconnect or interrupt the same, thereby also eliminating the eventual connection error which the checker operator may make.

Moreover, considering the eventual saturation of the cables in pre-existing plants and therefore also the unavailability of an idle pair for each distribution box, it is made use of the usual user pair to carry out the measurement.

This is carried out by checking that the user is in an idle condition, he/she is isolated for a few seconds and then reconnected.

Moreover, choosing moments of the day in which the telephone traffic is at a minimum, the measurement turns out to be uninfluential for the normal traffic.

An indirect advantage of the adopted system is to keep the integrity of the pair upon which the user is in conversation, under control at least up to box.

Indeed the remote earth resistance meter exploits both the wire 1 and the wire 2 of the pair and if it finds anomalies in the conversation with the remote device, it will signal that it has not been possible to carry out the measurement.

The system has been hypothesized for the earth resistance measurement of a telephone discharger, but the application is not excluded to other types of electric systems for the measurement of the earth resistance thereof.

Formal and structural variations of the system can be made without getting out of the scope of the present invention as defined by the enclosed claims.

## Claims

1. A remote earth resistance meter particularly fit to measure the earth resistance of the earth plates applied to the line dischargers in telephone systems, characterized in that it allows the earth resistance to be measured without having to disconnect the earth plate.

2. The remote meter according to Claim 1, characterized in that the measurement can be carried out also utilizing a user pair as a circuit.

3. The remote meter according to the preceding claims, characterized in that it provides an ammeter inserted in the earth cable.

4. The remote meter according to the preceding claims, characterized in that it provides an ammeter, a voltmeter remote from the earth connection, i.e. in the telephone exchange.

5. A remote meter according to the preceding claims, characterized in that the magnitude of the current measured on the earth cable is sent to the central station where the other measurements are made and the whole is processed.
